# EUROPÄISCHE PATENTSCHRIFT

(11) **EP 3 841 851 B1**
(45) Veröffentlichungstag und Bekanntmachung des Hinweises auf die Patenterteilung: **28.06.2023**
(21) Anmeldenummer: 19746053.8
(22) Anmeldetag: 22.07.2019
(51) Int. Cl.: H05K 5/00, H05K 5/06, H05K 7/14

(54) **GEHÄUSERAHMEN FÜR EIN STEUERGERÄT, WELCHER ZUR ELEKTRISCHEN AUSSENKONTAKTIERUNG EINES SCHALTUNGSTRÄGERS DES STEUERGERÄTS GEEIGNET IST**
HOUSING FRAME FOR A CONTROL UNIT, WHICH HOUSING FRAME IS SUITABLE FOR EXTERNALLY ELECTRICALLY CONTACTING A CIRCUIT CARRIER OF THE CONTROL UNIT
CADRE DE BOÎTIER POUR UNITÉ DE COMMANDE APPROPRIÉ AU CONTACT ÉLECTRIQUE EXTERNE D'UNE CARTE DE CIRCUIT IMPRIMÉ DE L'UNITÉ DE COMMANDE

(30) Priorität: 21.08.2018 DE 102018214059
(43) Veröffentlichungstag der Anmeldung: 30.06.2021
(73) Patentinhaber: Robert Bosch GmbH, 70442 Stuttgart (DE)
(72) Erfinder: JOCHAM, Reinhold, 72764 Reutlingen (DE); TRESCHER, Ulrich, 72072 Tuebingen (DE); BADER, Sascha, 73614 Schorndorf (DE); SCHILLI, Oliver, 72805 Lichtenstein (DE)
(86) Internationale Anmeldenummer: PCT/EP2019/069691
(87) Internationale Veröffentlichungsnummer: WO 2020/038678

(56) Entgegenhaltungen:
- DE-A1-102007 041 136
- US-A1- 2006 068 609

## Beschreibung

### Stand der Technik

Die Erfindung geht aus von einem Gehäuserahmen für ein Steuergerät zur Ansteuerung einer elektrischen Maschine, wobei der Gehäuserahmen wenigstens einen Anschlusspin zur elektrischen Kontaktierung eines Schaltungsträgers des Steuergeräts aufweist.

Typischerweise erfolgt die Kontaktierung des Schaltungsträgers bisher mittels Ultraschallbonden von Aluminium-Dickdrähtern oder -Bändchen auf den Schaltungsträger, welche dann beispielsweise nach außen geführt werden, um den Schaltungsträger elektrisch mit weiteren externen Bauteilen zu verbinden.

### Offenbarung der Erfindung

Die Erfindung ist in den Ansprüchen 1 und 9 definiert. Weitere Ausführungsbeispiele sind in den abhängigen Ansprüchen definiert.

Unter Gehäuserahmen ist ein Element zu verstehen, welches zumindest einen Teil eines Steuergeräts zur Ansteuerung einer elektrischen Maschine bildet. Der Gehäuserahmen ist hierbei im Wesentlichen aus Kunststoff gebildet. Unter im Wesentlichen aus Kunststoff gebildet ist hierbei wiederum zu verstehen, dass der Gehäuserahmen hauptsächlich Kunststoff aufweist und nur geringfügig, beispielsweise im einstelligen Prozentbereich, einen oder mehrere von Kunststoff verschiedene Stoffe aufweist. Diese von Kunststoff verschiedenen Stoffe können beispielsweise Verunreinigungen sein. Die von Kunststoff verschiedenen Stoffe können jedoch auch gezielt beigemischt sein um Eigenschaften, wie beispielsweise die Biegsamkeit oder Haltbarkeit, zu beeinflussen. Es ist jedoch auch denkbar, dass der Gehäuserahmen zusätzlich eine Glasfaserfüllung aufweist, welche besonders bevorzugt bis zu 30% des Gehäuserahmens bilden kann.

Unter Anschlusspin ist ein Bauelement zu verstehen, welches elektrischen Strom leiten kann und dazu dient, verschiedene andere Bauelemente elektrisch miteinander zu verbinden. In diesem Fall kann dies beispielsweise eine Verbindung zwischen einem elektronischen Bauelement des Steuergeräts und einer elektrischen Energiequelle sein, welche beispielsweise außerhalb des Steuergeräts angeordnet ist.

Ein Aspekt der Erfindung besteht darin, dass der Anschlusspin einen Anschlussfuß aufweist und derartig in den Gehäuserahmen eingespritzt ist, dass der Anschlusspin am Anschlussfuß mittels Laserstrahlschweißen mit dem Schaltungsträger elektrisch verbindbar ist.

Vorteilhaft ist hierbei, dass bei einer Laserstrahlschweißverbindung gegenüber einer Bondverbindung weniger Platz auf dem Schaltungsträger an der entsprechenden elektrischen Verbindungsstelle notwendig ist. Hierdurch kann das Schaltungsträger bei gleicher Funktion entweder kleiner gewählt werden oder aber es können mehr Bauteile als bisher auf dem Schaltungsträger verbaut werden.

In einer Ausgestaltung des erfindungsgemäßen Gehäuserahmens ist vorgesehen, dass der Anschlusspin einen federnd ausgebildeten Abschnitt aufweist.

Vorteilhaft ist hierbei, dass durch die federnde Wirkung eine Kraft auf den Anschlussfuß wirken kann, sobald der Gehäuserahmen entsprechend in einem Steuergerät verbaut ist, welche den Anschlussfuß auf den Schaltungsträger presst. Durch diese Kraft kann die Laserstrahlschweißverbindung dann einfach umgesetzt werden, ohne dass eine weitere mechanische Fixierung des Anschlusspins auf dem Schaltungsträger notwendig ist. Ein weiterer Vorteil besteht darin, dass bei einem Steuergerät, welches einen entsprechenden Gehäuserahmen aufweist, durch die federnde Wirkung des Anschlusspins thermomechanische Spannungen beim Betrieb des Steuergeräts ausgeglichen werden können. Hierdurch verlängert sich die Haltbarkeit der elektrischen Verbindung eines solchen Anschlusspins und somit auch die Haltbarkeit und Zuverlässigkeit des Steuergeräts.

Gemäß einer Ausgestaltung des erfindungsgemäßen Gehäuserahmens ist vorgesehen, dass der federnd ausgebildete Abschnitt des Anschlusspins L-förmig oder S-förmig ausgestaltet ist.

Vorteilhaft ist hierbei, dass dies einfache Möglichkeiten darstellt, eine federnde Wirkung des Anschlusspins zu erzielen.

Gemäß einer Ausgestaltung des erfindungsgemäßen Gehäuserahmens ist vorgesehen, dass die Querschnittsfläche des Anschlusspins in dem federnd ausgebildeten Abschnitt zumindest bereichsweise kleiner als außerhalb des federnd ausgebildeten Abschnitts ausgestaltet ist.

Vorteilhaft ist hierbei, dass eine besonders gute Federwirkung erzielt werden kann. Dies ist insbesondere für einen Anschlusspin geeignet, welche nur kleine Ströme leiten muss.

Gemäß einer Ausgestaltung des erfindungsgemäßen Gehäuserahmens ist vorgesehen, dass der Anschlussfuß mit einem vorbestimmten Winkel gegenüber einer Haupterstreckungsebene des Gehäuserahmens ausgestaltet ist. Vorteilhaft ist hierbei, dass im unverbauten Zustand des Gehäuserahmens ein entsprechender Winkel vorhanden ist, jedoch sobald der Gehäuserahmen in einem Steuergerät entsprechend eingebaut ist, der Anschlussfuß aufgrund der federnden Wirkung planparallel auf einem Anschlussträger aufliegt und zudem eine entsprechende Kraft auf den Anschlussfuß wirkt, welche diesen mechanisch fixiert, um ihn anschließend unkompliziert Laserstrahlschweißen zu können.

Unter Haupterstreckungsebene des Gehäuserahmens ist hierbei die Oberseite des Gehäuserahmens zu verstehen. Ist der Gehäuserahmen in ein Steuergerät eingebaut, liegt diese Oberseite parallel zur Haupterstreckungsebene des Schaltungsträgers sowie zur Haupterstreckungsebene des Kühlkörpers.

Die Erfindung betrifft zudem ein Steuergerät zur Ansteuerung einer elektrischen Maschine, wobei das Steuergerät einen Schaltungsträger und einen erfindungsgemäßen Gehäuserahmen aufweist, wobei der Anschlussfuß des Anschlusspins mit dem Schaltungsträger mittels Laserstrahlschweißen elektrisch verbunden ist.

Das erfindungsgemäße Steuergerät dient dazu, die elektrische Maschine entsprechend anzusteuern und zu betreiben.

Der Schaltungsträger und der Gehäuserahmen sind typischerweise auf einem Kühlkörper angeordnet. Unter Kühlkörper ist ein Element zu verstehen, welches vom Steuergerät erzeugte Wärme an die Umgebung abgeben kann. Hierbei wird die Wärme typischerweise von den elektronischen Bauelementen erzeugt, welche auf dem Schaltungsträger des Steuergeräts angeordnet sind. Zur Abgabe der Wärme kann der Kühlkörper beispielsweise zusätzlich Kühlfinnen auf seiner Unterseite aufweisen.

Gemäß einer Ausgestaltung des erfindungsgemäßen Steuergeräts ist vorgesehen, dass der Schaltungsträger als DBC-Substrat ausgestaltet ist. Vorteilhaft ist hierbei, dass durch das Laserstrahlschweißen im Gegensatz zum Ultraschallbonden keine zusätzlichen Oberflächenbeschichtungen des DBC-Substrats oder des Anschlusspins notwendig sind, insbesondere wenn der Anschlusspin ebenfalls im Wesentlichen aus Kupfer gebildet ist. Hierdurch wird die Herstellung des Steuergeräts vereinfacht und zudem werden die Kosten verringert.

Unter einem DBC-Substrat ist in der Aufbau- und Verbindungstechnik eine Struktur zu verstehen, die eine enge elektrisch/thermische Verbindung elektronischer Bauteile und Chips über Kupfer ermöglicht.

Die Erfindung betriff zudem eine elektrische Maschine, insbesondere einen Elektromotor, mit einem erfindungsgemäßen Steuergerät.

Unter Elektromotor ist hierbei beispielsweise eine Drehstrommaschine wie zum Beispiel eine Synchronmaschine oder eine Asynchronmaschine zu verstehen.

Des Weiteren betrifft die Erfindung ein Verfahren zum elektrischen Verbinden eines Anschlusspins eines erfindungsgemäßen Gehäuserahmens mit einem Schaltungsträger eines Steuergeräts.

### Zeichnungen

Fig. 1 zeigt einen Ausschnitt eines ersten Ausführungsbeispiels eines erfindungsgemäßen Gehäuserahmens in perspektivischer Ansicht.
Fig. 2 zeigt einen Schnitt durch den erfindungsgemäßen Gehäuserahmen gemäß Fig. 1.
Fig. 3 zeigt einen Schnitt durch ein erfindungsgemäßes Steuergerät, welches einen erfindungsgemäßen Gehäuserahmen gemäß Fig. 1 bzw. Fig. 2 aufweist.
Fig. 4 zeigt einen Ausschnitt eines zweiten Ausführungsbeispiels eines erfindungsgemäßen Gehäuserahmens in perspektivischer Ansicht.
Fig. 5 zeigt einen Schnitt durch den erfindungsgemäßen Gehäuserahmen gemäß Fig. 4.
Fig. 6 zeigt einen Schnitt durch ein erfindungsgemäßes Steuergerät, welches einen erfindungsgemäßen Gehäuserahmen gemäß Fig. 4 bzw. Fig. 5 aufweist.
Fig. 7 zeigt ein Ausführungsbeispiel einer schematisch dargestellten, erfindungsgemäßen elektrischen Maschine mit einem erfindungsgemäßen Steuergerät in einer perspektivischen Ansicht.
Fig. 8 zeigt ein Verfahren zum elektrischen Verbinden eines Anschlusspins eines erfindungsgemäßen Gehäuserahmens mit einem Schaltungsträger eines Steuergeräts.

### Beschreibung von Ausführungsbeispielen

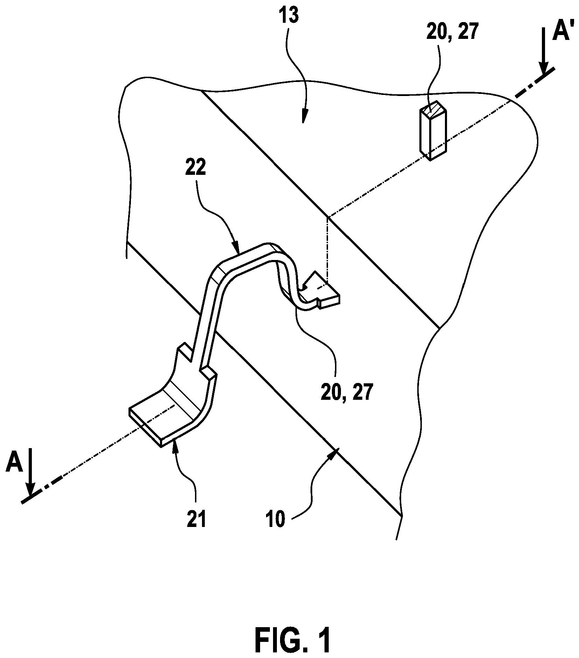

Fig. 1 zeigt einen Ausschnitt eines ersten Ausführungsbeispiels eines erfindungsgemäßen Gehäuserahmens in perspektivischer Ansicht. Dargestellt ist eine Gehäuserahmen 10. In den Gehäuserahmen 10 ist ein Anschlusspin 20 eingespritzt. Dieser Anschlusspin 20 ist als Signalpin 27 ausgestaltet. Unter Signalpin 27 ist ein Element zu verstehen, über welches elektrische Signale geleitet werden können. Diese elektrischen Signale liegen in Form von Strömen vor, wobei die Ströme beziehungsweise Spannungen am Signalpin 27 typischerweise klein sind. So ist die Stromstärke des Signalpins 27 geringer als 1A, typischerweise sogar nur wenige mA groß. Dagegen kann die Stromstärke des Leistungspins 25 bis etwa 100A betragen, wobei typischerweise 80 bis 110A kurzzeitig getaktet anliegen.

Der Anschlusspin 20 weist einen federnden ausgebildeten Abschnitt 22 auf, welcher S-förmig ausgestaltet ist. Des Weiteren weist der Anschlusspin 20 einen Anschlussfuß 21 auf, an welchem der Anschlusspin 20 mit einem nicht dargestellten Schaltungsträger 30 mittels Laserstrahlschweißen elektrisch verbindbar ist. Zudem ist ersichtlich, dass die Querschnittsfläche des Anschlusspins 20 in dem federnd ausgebildeten Abschnitt 22 zumindest bereichsweise kleiner als außerhalb des federnd ausgebildeten Abschnitts 22 ausgestaltet ist, insbesondere kleiner als am Anschlussfuß 21 des Anschlusspins 20.

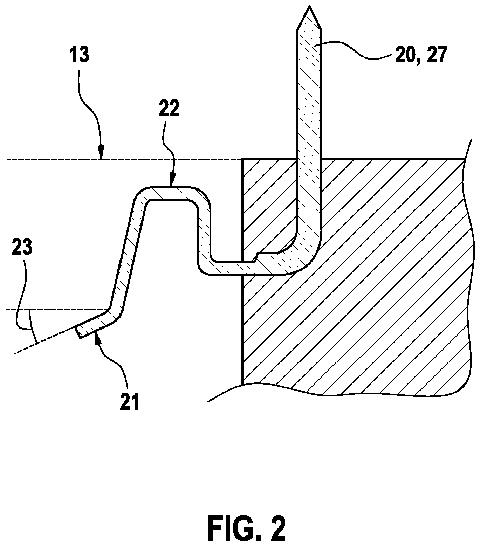

Fig. 2 zeigt einen Schnitt durch den erfindungsgemäßen Gehäuserahmen gemäß Fig. 1.

Der Schnitt verläuft hierbei senkrecht entlang der in Fig. 1 gezeigten Schnittgeraden A-A`.

Es ist wiederum der Gehäuserahmen 10 mit dem als Signalpin 27 ausgestalteten Anschlusspin 20 dargestellt. Hierbei ist ersichtlich, dass der Anschlussfuß 21 des Anschlusspins 20 einen vorbestimmten Winkel 23 mit der Haupterstreckungsebene 13 des Gehäuserahmens 10 aufspannt. Wobei dieser Winkel 23 gegeben ist, wenn der Anschlusspin 20 des Gehäuserahmens 10 nicht mit einem Schaltungsträger 30 verbunden ist und somit der Anschlusspin 20 noch keine Federkraft aufweist.

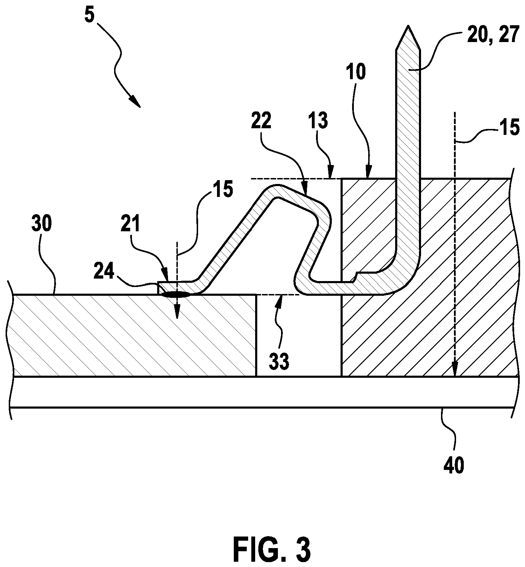

Fig. 3 zeigt einen Schnitt durch ein erfindungsgemäßes Steuergerät, welches einen erfindungsgemäßen Gehäuserahmen gemäß Fig. 1 bzw. Fig. 2 aufweist. Dargestellt ist ein Steuergerät 5, welches einen Kühlkörper 40, einen Schaltungsträger 30 und einen Gehäuserahmen 10 gemäß Fig. 1 bzw. Fig. 2 aufweist. Der Gehäuserahmen 10 ist hierbei derartig auf den Kühlkörper 40 gepresst, dass der Anschlussfuß 21 des federnd ausgebildeten Anschlusspins 20 planparallel zur Haupterstreckungsebene 33 des Schaltungsträgers 30 auf diesem Schaltungsträger 30 aufliegt. Der Gehäuserahmen 10 ist hierbei in senkrechter Richtung 15 zur Haupterstreckungsebene 13 des Gehäuserahmens 10 auf den Kühlkörper aufgepresst worden. Der Gehäuserahmen 10 kann hierbei optional mittels einer nicht dargestellten Nietverbindung entsprechend auf dem Kühlkörper 40 fixiert sein. Der Gehäuserahmen 10 und dessen Anschlusspin 20 sind hierbei derartig ausgestaltet, dass der Anschlussfuß 21 des Anschlusspins 20 planparallel auf dem Schaltungsträger 30 aufliegt und durch den federnden Abschnitt 22 eine Kraft 16 in senkrechter Richtung 15 zur Haupterstreckungsebene 13 des Gehäuserahmens 10 erzeugt wird, welche den Anschlussfuß 21 auf den Schaltungsträger presst. Des Weiteren ist der Anschlussfuß 21 mit dem Schaltungsträger 30 mittels einer Laserstrahlschweißverbindung 24 elektrisch verbunden. Hierdurch wird es ermöglicht, dass beispielsweise ein anderes elektronisches Bauteil oder eine Energiequelle, welche bildlich nicht dargestellt sind, mit dem Schaltungsträger 30 elektrisch verbunden werden kann, indem das dem Anschlussfuß 21 gegenüberliegende Ende des Anschlusspins 20 entsprechend nach Außen geführt und kontaktierbar ist.

Beim Vergleich der Fig. 2 und der Fig. 3 ist zudem erkennbar, dass der Anschlussfuß 21 beim unverbauten Gehäuserahmen 10 gemäß Fig. 2 einen entsprechenden vertikalen Abstand zur Ebene des Gehäuserahmens 10 aufweist, welche bei verbautem Gehäuserahmen 10 gemäß Fig. 3 auf dem Kühlkörper aufliegt, der kleiner ist als der vertikale Abstand zwischen der Ebene des Gehäuserahmens 10, welche bei verbautem Gehäuserahmen 10 gemäß Fig. 3 auf dem Kühlkörper aufliegt, und der Oberseite des Schaltungsträgers 30. Durch die Ausgestaltung des Anschlusspins 20 und des Gehäuserahmens 10 derartig, dass ein Unterschied beim nominalen vertikalen Abstand zwischen unverbauten und verbauten Gehäuserahmen 10 entsteht, kommt es zur Federwirkung des Anschlusspins 20 im federnd ausgestalteten Abschnitt 22, wenn der Gehäuserahmen 10 entsprechen in ein Steuergerät 5 eingebaut ist.

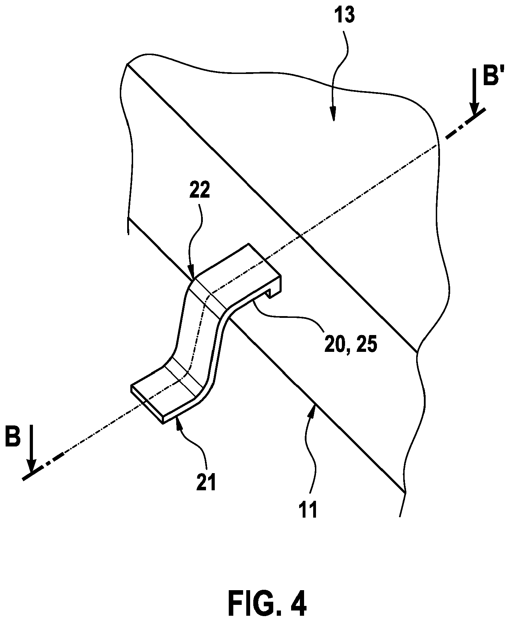

Fig. 4 zeigt einen Ausschnitt eines zweiten Ausführungsbeispiels eines erfindungsgemäßen Gehäuserahmens in perspektivischer Ansicht. Dargestellt ist ein Gehäuserahmen 11. In den Gehäuserahmen 11 ist wiederum ein Anschlusspin 20 eingespritzt. Dieser Anschlusspin 20 ist als Leistungspin 25 ausgestaltet. Als Leistungspin 25 ist ein Anschlusspin 20 zu verstehen, über welchen Ströme mit deutlich höheren Stromstärken im Vergleich zum Signalpin 27 fließen können. Der Anschlusspin 20 weist wiederum einen federnden ausgebildeten Abschnitt 22 auf, welcher im Gegensatz zu dem Signalpin 27 jedoch L-förmig ausgestaltet ist. Des Weiteren weist der Anschlusspin 20 einen Anschlussfuß 21 auf, an welchem der Anschlusspin 20 mit einem nicht dargestellten Schaltungsträger 30 mittels Laserstrahlschweißen elektrisch verbindbar ist.

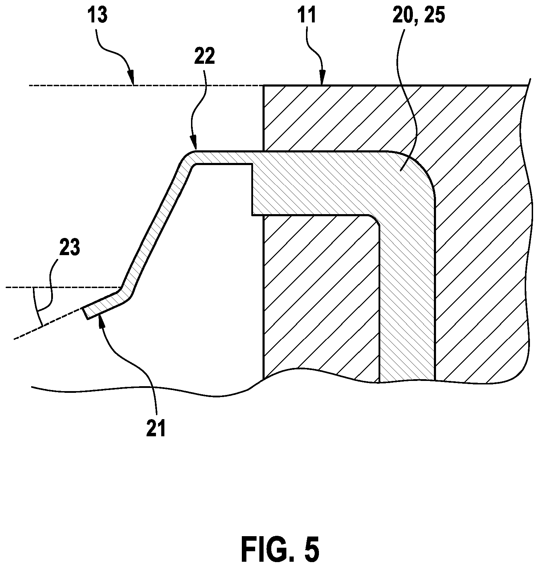

Fig. 5 zeigt einen Schnitt durch den erfindungsgemäßen Gehäuserahmen gemäß Fig. 4.

Der Schnitt verläuft hierbei senkrecht entlang der in Fig. 4 gezeigten Schnittgeraden B-B'.

Es ist wiederum der Gehäuserahmen 11 mit dem als Leistungspin 25 ausgestalteten Anschlusspin 20 dargestellt. Hierbei ist ersichtlich, dass der Anschlussfuß 21 des Anschlusspins 20 wiederum einen vorbestimmten Winkel 23 mit der Haupterstreckungsebene 13 des Gehäuserahmens 11 aufspannt. Wobei dieser Winkel 23 gegeben ist, wenn der Anschlusspin 20 des Gehäuserahmens 11 nicht mit einem Schaltungsträger 30 verbunden ist.

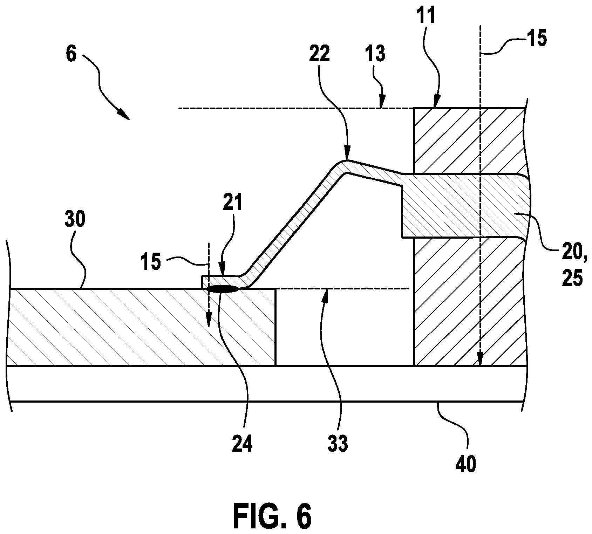

Fig. 6 zeigt einen Schnitt durch ein erfindungsgemäßes Steuergerät, welches einen erfindungsgemäßen Gehäuserahmen gemäß Fig. 4 bzw. Fig. 5 aufweist. Dargestellt ist ein Steuergerät 6, welches einen Kühlkörper 40, einen Schaltungsträger 30 und einen Gehäuserahmen 11 gemäß Fig. 4 bzw. Fig. 5 aufweist. Der Aufbau des Steuergeräts 6 gemäß Fig. 6 entspricht hierbei im Wesentlichen dem des Steuergeräts 5 gemäß Fig. 3 und unterscheidet sich lediglich durch den leicht unterschiedlich ausgestalteten Anschlusspin 20, welcher beim Steuergerät 6 gemäß Fig. 6 als Leistungspin 25 und nicht wie beim Steuergerät 5 gemäß Fig. 3 als Signalpin 27 ausgestaltet ist.

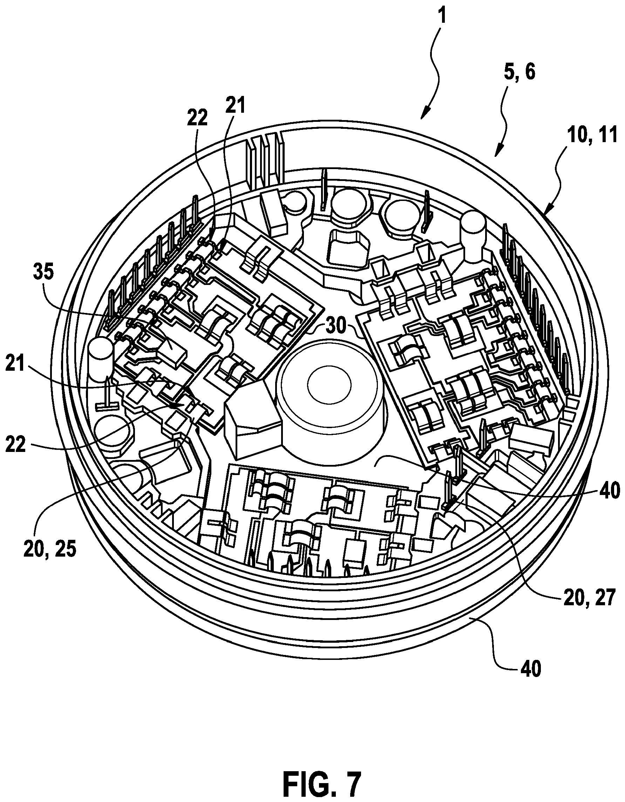

Fig. 7 zeigt ein Ausführungsbeispiel einer schematisch dargestellten, erfindungsgemäßen elektrischen Maschine mit einem erfindungsgemäßen Steuergerät in einer perspektivischen Ansicht.

Dargestellt ist eine elektrische Maschine 1. Diese elektrische Maschine 1 kann beispielsweise als Elektromotor und insbesondere als Synchronmaschine oder als Asynchronmaschine ausgestaltet sein und somit eine Drehstrommaschine bilden. Die elektrische Maschine 1 weist ein Steuergerät 5, 6 auf. Das Steuergerät 5, 6 weist wiederum einen Kühlkörper 40 und mehrere Schaltungsträger 30 auf. Die Schaltungsträger 30 sind hierbei als DBC-Substrate ausgestaltet. Zudem weist das Steuergerät 5 einen Gehäuserahmen 10, 11 auf. Der Gehäuserahmen 10, 11 weist hierbei eine Vielzahl von Anschlusspins 20 auf, die teilweise als Signalpins 27 beispielsweise gemäß Fig. 1 bis 3 oder auch als Leistungspins 25 gemäß Fig. 4 bis 6 ausgestaltet und entsprechend mittels Laserstrahlschweißen mit den Schaltungsträgern 30 elektrisch verbunden sind. Die Schaltungsträger 30 sind wiederum beispielhaft mit elektronischen Bauelementen 35 bestückt, welche beispielsweise als Bare-Die-Bauelemente ausgestaltet sind. Diese elektronischen Bauelemente 35 können beispielsweise Kondensatoren, Halbleiterschalter, Spulen, Sensoren oder Energiespeicher sein, um eine entsprechende elektronische Schaltung für die Ansteuerung und das Betreiben der elektrischen Maschine 5 zu ermöglichen. Hierdurch sind die elektronischen Bauelemente 35 über die Anschlusspins 20 von außerhalb des Steuergeräts 5, 6 elektrisch kontaktierbar.

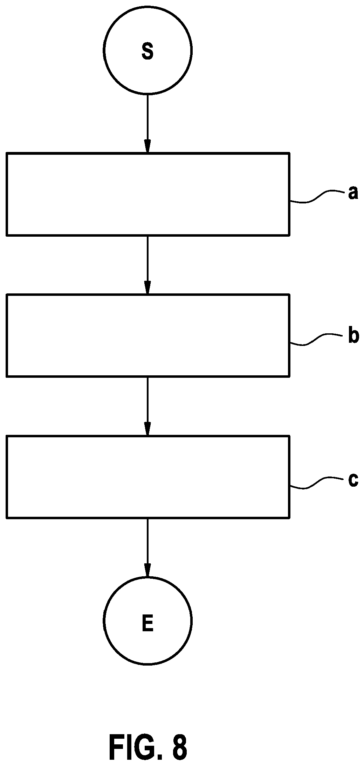

Fig. 8 zeigt ein Verfahren zum elektrischen Verbinden eines Anschlusspins eines erfindungsgemäßen Gehäuserahmens mit einem Schaltungsträger eines Steuergeräts.

Hierbei wird zu Beginn des Verfahrens in einem Verfahrensschritt a ein erfindungsgemäßer Gehäuserahmen 10,11 beispielsweise gemäß Fig. 1 und 2 oder auch gemäß Fig. 4 und 5 bereitgestellt. Zudem wird im Verfahrensschritt a ein auf einem Kühlkörper 40 angeordneter Schaltungsträger 30 bereitgestellt. Der Schaltungsträger 30 kann hierbei als DBC-Substrat ausgestaltet sein.

In einem Verfahrensschritt b wird anschließend der Gehäuserahmen 10, 11 derartig auf den Kühlkörper 40 des Steuergeräts 5, 6 in senkrechter Richtung 15 zur Haupterstreckungsebene 13 des Gehäuserahmens 10, 11 gepresst, dass der Anschlussfuß 21 des Anschlusspins 20 planparallel zur Haupterstreckungsebene 33 des Schaltungsträger 30 auf dem Schaltungsträger 30 aufliegt. Insbesondere ist der Gehäuserahmen 10, 11 und dessen Anschlusspin 20 hierbei derartig ausgestaltet, dass zusätzlich zum planparallelen Aufliegen des Anschlussfußes 21 auf den Schaltungsträger 30 aufgrund des federnd ausgestalteten Abschnitts 22 eine Kraft 16 in senkrechter Richtung 15 zur Haupterstreckungsebene 33 des Schaltungsträger 30 auf den Anschlussfuß 21 wirkt, welche den Anschlussfuß 21 auf den Schaltungsträger 30 presst. Anschließend wird in einem Verfahrensschritt c der Anschlussfuß 22 mit dem Schaltungsträger laserstrahlgeschweißt, um eine Laserstrahlschweißverbindung 24 zu erzeugen, welche eine elektrische Verbindung zwischen Schaltungsträger 30 und Anschlusspin 20 ermöglicht.

## Patentansprüche

1. Gehäuserahmen (10, 11) ausgebildet für ein Steuergerät (5, 6) zur Ansteuerung einer
elektrischen Maschine (1), wobei der Gehäuserahmen (10, 11) wenigstens einen Anschlusspin (20) zur elektrischen Kontaktierung eines Schaltungsträgers (30) des Steuergeräts (5, 6) aufweist,
**dadurch gekennzeichnet, dass**
der Anschlusspin (20) einen Anschlussfuß (21) aufweist und derartig in den Gehäuserahmen (10, 11) eingespritzt ist, dass der Anschlusspin (20) am Anschlussfuß (21) mittels Laserstrahlschweißen mit dem Schaltungsträger (30) elektrisch verbindbar ist, und dass der federnd ausgebildete Anschlusspin (20) durch Pressen des Gehäuserahmens (10, 11) auf einen Kühlkörper (40) des Steuergeräts (5, 6) in senkrechter Richtung (15) zur Haupterstreckungsebene (13) des Gehäuserahmens (10, 11) planparallel auf dem Schaltungsträger (30) aufliegt.

2. Gehäuserahmen (10, 11) nach Anspruch 1, **dadurch gekennzeichnet, dass** der Anschlusspin (20) einen federnd ausgebildeten Abschnitt (22) aufweist.

3. Gehäuserahmen (10, 11) nach Anspruch 2, **dadurch gekennzeichnet, dass** der federnd ausgebildete Abschnitt (22) des Anschlusspins L-förmig oder S-förmig ausgestaltet ist.

4. Gehäuserahmen (10) nach Anspruch 2 oder 3, **dadurch gekennzeichnet, dass** die Querschnittsfläche des Anschlusspins (20) in dem federnd ausgebildeten Abschnitt (22) zumindest bereichsweise kleiner als außerhalb des federnd ausgebildeten Abschnitts (22) ausgestaltet ist.

5. Gehäuserahmen (10, 11) nach einem der Ansprüche 2 bis 4, **dadurch gekennzeichnet, dass** der Anschlussfuß (21) mit einem vorbestimmten Winkel (24) gegenüber einer Haupterstreckungsebene (13) des Gehäuserahmens (10, 11) ausgestaltet ist.

6. Steuergerät (5, 6) zur Ansteuerung einer elektrischen Maschine (1), wobei das Steuergerät (5, 6) einen Schaltungsträger (30) und einen Gehäuserahmen (10, 11) nach einem der Ansprüche 1 bis 5 aufweist, wobei der Anschlussfuß (21) des Anschlusspins (20) mit dem Schaltungsträger (30) mittels Laserstrahlschweißen elektrisch verbunden ist.

7. Steuergerät (5,6) nach Anspruch 6, **dadurch gekennzeichnet, dass** der Schaltungsträger (30) als DBC-Substrat ausgestaltet ist.

8. Elektrische Maschine (1) mit einem Steuergerät (5, 6) nach Anspruch 7.

9. Verfahren zum elektrischen Verbinden eines Anschlusspins eines Gehäuserahmens (10, 11) nach einem der Ansprüche 1 bis 5 mit einem Schaltungsträger (30) eines Steuergeräts (5, 6), **gekennzeichnet durch** wenigstens folgende Verfahrensschritte:
a. Bereitstellen eines Gehäuserahmens (10, 11) nach einem der Ansprüche 1 bis 5 sowie eines auf einem Kühlkörper (40) angeordneten Schaltungsträgers (30) eines Steuergeräts (5, 6),
b. Pressen des Gehäuserahmens (10, 11) auf den Kühlkörper (40) des Steuergeräts (5, 6) in senkrechter Richtung (15) zur Haupterstreckungsebene (13) des Gehäuserahmens (10, 11) derartig, dass der Anschlussfuß (21) des federnd ausgebildeten Anschlusspins (20) planparallel zur Haupterstreckungsebene (33) des Schaltungsträger (30) auf dem Schaltungsträger (30) aufliegt,
c. Laserstrahlschweißen des Anschlussfuß (21) mit dem Schaltungsträger (30).

10. Verfahren nach Anspruch 9, **dadurch gekennzeichnet, dass** der im Verfahrensschritt a bereitgestellte Schaltungsträger (30) als DBC-Substrat ausgestaltet ist.

## Claims

1. Housing frame (10, 11) designed for a control unit (5, 6) for driving an electrical machine (1), wherein the housing frame (10, 11) has at least one connection pin (20) for electrically contacting a circuit carrier (30) of the control unit (5, 6),
**characterized in that**
the connection pin (20) has a connection foot (21) and is injection-moulded into the housing frame (10, 11) in such a way that the connection pin (20) can be electrically connected to the circuit carrier (30) at the connection foot (21) by means of laser welding, and **in that** the resilient connection pin (20) rests planeparallel on the circuit carrier (30) by pressing the housing frame (10, 11) onto a heat sink (40) of the control unit (5, 6) in the perpendicular direction (15) in relation to the main plane of extent (13) of the housing frame (10, 11).

2. Housing frame (10, 11) according to Claim 1, **characterized in that** the connection pin (20) has a resilient section (22).

3. Housing frame (10, 11) according to Claim 2, **characterized in that** the resilient section (22) of the connection pin is configured in an L-shape or S-shape.

4. Housing frame (10) according to Claim 2 or 3, **characterized in that** the cross-sectional area of the connection pin (20) in the resilient section (22) is configured to be smaller than outside the resilient section (22) at least in regions.

5. Housing frame (10, 11) according to one of Claims 2 to 4, **characterized in that** the connection foot (21) is configured with a predetermined angle (24) in relation to a main plane of extent (13) of the housing frame (10, 11) .

6. Control unit (5, 6) for driving an electrical machine (1), wherein the control unit (5, 6) has a circuit carrier (30) and a housing frame (10, 11) according to one of Claims 1 to 5, wherein the connection foot (21) of the connection pin (20) is electrically connected to the circuit carrier (30) by means of laser welding.

7. Control unit (5, 6) according to Claim 6, **characterized in that** the circuit carrier (30) is configured as a DBC substrate.

8. Electrical machine (1) comprising a control unit (5, 6) according to Claim 7.

9. Method for electrically connecting a connection pin of a housing frame (10, 11) according to one of Claims 1 to 5 to a circuit carrier (30) of a control unit (5, 6), **characterized by** at least the following method steps:
a. providing a housing frame (10, 11) according to one of Claims 1 to 5 and a circuit carrier (30) of a control unit (5, 6), which circuit carrier is arranged on a heat sink (40),
b. pressing the housing frame (10, 11) onto the heat sink (40) of the control unit (5, 6) in the perpendicular direction (15) in relation to the main plane of extent (13) of the housing frame (10, 11) in such a way that the connection foot (21) of the resilient connection pin (20) rests on the circuit carrier (30) in a manner planeparallel in relation to the main plane of extent (33) of the circuit carrier (30),
c. laser welding the connection foot (21) to the circuit carrier (30).

10. Method according to Claim 9, **characterized in that** the circuit carrier (30) which is provided in method step a is configured as a DBC substrate.

## Revendications

1. Cadre de boîtier (10, 11) configuré pour un dispositif de commande (5, 6) destiné à la commande d'une machine électrique (1), le cadre de boîtier (10, 11) possédant au moins une broche de raccordement (20) servant à la mise en contact électrique avec un porte-circuit (30) du dispositif de commande (5, 6),
**caractérisé en ce que**
la broche de raccordement (20) possède une patte de raccordement (21) et est injectée dans le cadre de boîtier (10, 11) de telle sorte que la broche de raccordement (20) peut être reliée électriquement au porte-circuit (30) au niveau de la patte de raccordement (21) au moyen de soudage laser, et **en ce que** la broche de raccordement (20), réalisée en faisant ressort, repose en plans parallèles sur le porte-circuit (30) par pressage du cadre de boîtier (10, 11) sur un dissipateur thermique (40) du dispositif de commande (5, 6) dans la direction perpendiculaire (15) par rapport au plan d'extension principal (13) du cadre de boîtier (10, 11).

2. Cadre de boîtier (10, 11) selon la revendication 1, **caractérisé en ce que** la broche de raccordement (20) possède une portion (22) réalisée en faisant ressort.

3. Cadre de boîtier (10, 11) selon la revendication 2, **caractérisé en ce que** la portion (22) réalisée en faisant ressort de la broche de raccordement est configurée en forme de L ou en forme de S.

4. Cadre de boîtier (10, 11) selon la revendication 2 ou 3, **caractérisé en ce que** l'aire de la section transversale de la broche de raccordement (20) dans la portion (22) réalisée en faisant ressort est configurée, au moins par zones, plus petite qu'à l'extérieur de la portion (22) réalisée en faisant ressort.

5. Cadre de boîtier (10, 11) selon l'une quelconque des revendications 2 à 4, **caractérisé en ce que** la patte de raccordement (21) est réalisée avec un angle (24) prédéterminé par rapport à un plan d'extension principal (13) du cadre de boîtier (10, 11).

6. Dispositif de commande (5, 6) destiné à commander une machine électrique (1), le dispositif de commande (5, 6) possédant un porte-circuit (30) et un cadre de boîtier (10, 11) selon l'une quelconque des revendications 1 à 5, la patte de raccordement (21) de la broche de raccordement (20) étant reliée électriquement au porte-circuit (30) au moyen de soudage laser.

7. Dispositif de commande (5, 6) selon la revendication 6, **caractérisé en ce que** le porte-circuit (30) est réalisé sous forme de substrat DBC.

8. Machine électrique (1) comprenant un dispositif de commande (5, 6) selon la revendication 7.

9. Procédé de connexion électrique d'une broche de raccordement d'un cadre de boîtier (10, 11) selon l'une quelconque des revendications 1 à 5 avec un porte-circuit (30) d'un dispositif de commande (5, 6), **caractérisé par** au moins les étapes de processus suivantes :
a. fourniture d'un cadre de boîtier (10, 11) selon l'une quelconque des revendications 1 à 5 ainsi que d'un porte-circuit (30) d'un dispositif de commande (5, 6), disposé sur un dissipateur thermique (40),
b. pressage du cadre de boîtier (10, 11) sur le dissipateur thermique (40) du dispositif de commande (5, 6) dans la direction perpendiculaire (15) au plan d'extension principal (13) du cadre de boîtier (10, 11), de telle sorte que la patte de raccordement (21) de la broche de raccordement (20) à configuration en faisant ressort repose en plans parallèles sur le porte-circuit (30) par rapport au plan d'extension principal (33) du porte-circuit (30),
c. soudage laser de la patte de raccordement (21) avec le porte-circuit (30).

10. Procédé selon la revendication 9, **caractérisé en ce que** le porte-circuit (30) fourni à l'étape a du processus est réalisé sous forme de substrat DBC.
